# FASCICULE DE BREVET EUROPEEN

(11) **EP 2 683 665 B1**
(45) Date de publication et mention de la délivrance du brevet: **30.05.2018**
(21) Numéro de dépôt: 12713214.0
(22) Date de dépôt: 08.03.2012
(51) Int. Cl.: C03C 3/087, H01L 31/0392

(54) **SUBSTRAT POUR CELLULE PHOTOVOLTAÏQUE**
SUBSTRAT FÜR EINE PHOTOVOLTAIKZELLE
SUBSTRATE FOR A PHOTOVOLTAIC CELL

(30) Priorité: 09.03.2011 FR 1151937
(43) Date de publication de la demande: 15.01.2014
(73) Titulaire: Saint-Gobain Glass France, 92400 Courbevoie (FR)
(72) Inventeur: CINTORA, Octavio, 95150 Taverny (FR); FOURTY, Guillaume, 75019 Paris (FR)
(74) Mandataire: Saint-Gobain Recherche
(86) Numéro de dépôt international: PCT/FR2012/050485
(87) Numéro de publication internationale: WO 2012/146844

(56) Documents cités:
- EP-A1- 1 281 687
- FR-A1- 2 764 596
- FR-A1- 2 765 569
- FR-A1- 2 911 868
- JP-A- 2008 280 189
- US-A1- 2009 223 252
- US-A1- 2010 129 944
- US-A1- 2010 300 535
- US-A1- 2011 017 297

## Description

L'invention se rapporte au domaine des substrats pour cellules photovoltaïques. Elle concerne plus précisément des substrats pour cellules photovoltaïques comprenant au moins une feuille de verre flotté munie sur une face d'au moins une électrode.

L'utilisation d'un matériau photovoltaïque en couches minces, typiquement en CdTe ou en Cu(In,Ga)Se₂ (CIGS), permet de remplacer des substrats coûteux en silicium par des substrats comprenant des feuilles de verre. Le matériau à propriétés photovoltaïques, et généralement l'électrode, sont déposées en couche mince par des procédés de dépôt du type évaporation, pulvérisation cathodique, dépôt chimique en phase vapeur (CVD) ou encore sublimation (CSS) sur la feuille de verre. Cette dernière doit généralement être chauffée à haute température, soit pendant le dépôt, soit après le dépôt (traitement de recuit, de sélénisation etc...), et subit de ce fait des températures de l'ordre de 500°C ou plus. Ces traitements permettent par exemple d'améliorer la cristallinité des couches et donc leurs propriétés de conduction électronique ou photovoltaïques.

Les hautes températures présentent toutefois l'inconvénient de provoquer une déformation de la feuille de verre lorsqu'elle est en verre silico-sodo-calcique standard.

Des verres de plus haute résistance thermique ont été proposés, mais présentent un coût de production élevé, du fait par exemple de l'utilisation de matières premières coûteuses (porteurs de baryum ou de strontium par exemple), ou de températures de fusion particulièrement élevées. En outre, certains de ces verres se prêtent mal au formage du verre par flottage.

On connaît par exemple des demandes US20100300535 et US20110017297 des compositions de verre de type aluminosilicate présentant une résistance améliorée aux températures élevées utilisées lors de la fabrication de cellules photovoltaïques CIS. Les verres aluminosilicates (ou borosilicates) présentent toutefois une aptitude à la rayure plus élevée, un poids plus important du fait d'une plus grande densité, ainsi qu'un indice de réfraction plus élevé, obligeant les fabricants de cellules photovoltaïques à modifier les réglages de focalisation du laser lors des étapes de gravure par laser des électrodes, notamment en molybdène.

L'invention a pour but d'obvier à ces inconvénients, en proposant une composition de verre présentant une résistance thermique améliorée le rendant compatible avec les procédés utilisés lors de la fabrication de cellules à base de matériaux photovoltaïques en couche mince, en Cu(In,Ga)Se₂ (CIGS), permettant en outre de produire un verre par flottage et dans des conditions économiques très favorables.

A cet effet, un objet de l'invention est un substrat pour cellule photovoltaïque comprenant au moins une feuille de verre flotté munie sur une face d'au moins une électrode, caractérisé en ce que ledit verre possède une composition chimique comprenant les constituants suivants, en une teneur pondérale variant dans les limites ci-après définies :

| | |
|---|---|
| SiO₂ | 69-75% |
| Al₂O₃ | 0-3% |
| CaO + MgO | 11-16,2% |
| MgO | 0-6,5% |
| Na₂O | 9-12,4%, notamment 9-12%, |
| K₂O | 0-1,5%. |

Tout en étant de type silico-sodo-calcique, comme le verre standard, ces compositions permettent de manière étonnante de conférer des résistances thermiques élevées aux substrats de verre, caractérisées notamment par des températures inférieures de recuit d'au moins 30°C plus élevées que celles du verre standard.

La somme des teneurs pondérales en SiO₂, Al₂O₃, CaO, MgO, Na₂O, K₂O est de préférence d'au moins 95%, notamment 98%. La teneur en SrO, BaO et/ou ZrO₂ est avantageusement nulle afin de ne pas pénaliser le coût de la feuille de verre. La teneur en oxydes d'antimoine et d'arsenic est également avantageusement nulle car ces oxydes ne sont pas compatibles avec le procédé de flottage. Les autres constituants de la composition peuvent être des impuretés provenant des matières premières (notamment l'oxyde de fer) ou dues à la dégradation des réfractaires du four de fusion ou des agents d'affinage (notamment SO₃).

La silice (SiO₂) est le principal élément formateur du verre. En de trop faibles teneurs, la résistance hydrolytique du verre, notamment en milieu basique, s'en trouverait trop amoindrie. En revanche, les teneurs au-delà de 75% entraînent une augmentation de la viscosité du verre hautement préjudiciable. La teneur en silice est de préférence d'au moins 70%, notamment 71% et/ou d'au plus 74%, notamment 73%.

L'alumine (Al₂O₃) permet d'augmenter la résistance hydrolytique du verre et de diminuer son indice de réfraction, ce dernier avantage étant particulièrement significatif lorsque le substrat est destiné à constituer le substrat de face avant de la cellule photovoltaïque. La teneur en alumine est de préférence d'au moins 0,5%, notamment 1%, 1,5% ou 2% et/ou d'au plus 2,5%.

L'ajout de chaux (CaO) présente l'avantage de diminuer la viscosité à haute température du verre, et donc de faciliter sa fusion et son affinage, tout en augmentant la température inférieure de recuisson, et donc la stabilité thermique. L'augmentation de la température au liquidus et de l'indice de réfraction attribuables à cet oxyde conduisent toutefois à en limiter la teneur. La magnésie (MgO) est utile pour améliorer la durabilité chimique du verre et diminuer sa viscosité. De fortes teneurs conduisent toutefois à renforcer les risques de dévitrification. La teneur en CaO est de préférence d'au moins 8%, voire 9% et même 10% et/ou d'au plus 13%, notamment 12%.

La soude (Na₂O) est utile pour réduire la viscosité à haute température et la température au liquidus. Des teneurs trop élevées conduisent toutefois à dégrader la résistance hydrolytique du verre et sa stabilité thermique, tout en augmentant le coût. La potasse (K₂O) présente les mêmes avantages et inconvénients. La teneur en Na₂O est de préférence d'au moins 9,5%, notamment 10% ou 11%, voire 11,5% et/ou d'au plus 12%. La teneur en K₂O est de préférence d'au plus 1%, notamment 0,5%, et même 0,3%, voire 0,1%. Il semblerait en effet que la potasse diminue de manière importante la température inférieure de recuit du verre.

Selon un premier mode de réalisation préféré, la teneur pondérale en MgO est d'au plus 1%, notamment 0,5% et même 0,1%. La teneur en CaO est avantageusement d'au moins 11,5%, voire 12%. La teneur en Na₂O est de préférence d'au moins 10%, voire 11%. Elle est avantageusement d'au plus 12%. Des compositions particulièrement préférées comprennent les constituants suivants, en une teneur pondérale variant dans les limites ci-après définies :

| | |
|---|---|
| SiO₂ | 71-74,2% |
| Al₂O₃ | 0-3% |
| CaO | 11,5-13% |
| MgO | 0-1% |
| Na₂O | 11-12,4%, notamment 11-12%, |
| K₂O | 0-1,5%. |

Selon un second mode de réalisation préféré, la teneur pondérale en MgO est d'au moins 4%, voire 4,5% ou 5% et/ou d'au moins 6%. La teneur en CaO est de préférence comprise entre 9 et 11%, notamment entre 9 et 10,5%. La teneur en Na₂O est avantageusement d'au moins 9,5%, voire 10% et/ou d'au plus 12% ou 11%. Des compositions particulièrement préférées comprennent les constituants suivants, en une teneur pondérale variant dans les limites ci-après définies :

| | |
|---|---|
| SiO₂ | 70-74% |
| Al₂O₃ | 0-2% |
| CaO | 9-10,5% |
| MgO | 4-6,5%, notamment 4-6% |
| Na₂O | 10-11% |
| K₂O | 0-1%. |

Selon un troisième mode de réalisation, la teneur pondérale en CaO est d'au moins 9%, notamment 10% et/ou d'au plus 12%, notamment 11%. La teneur pondérale en MgO est de préférence d'au moins 4% et/ou d'au plus 5%. La teneur en Na₂O est de préférence d'au moins 11%.

Des compositions particulièrement préférées comprennent les constituants suivants, en une teneur pondérale variant dans les limites ci-après définies :

| | |
|---|---|
| SiO₂ | 69-72%, notamment 69-71% |
| Al₂O₃ | 1-3%, notamment 1,7-3% |
| CaO | 10-12%, notamment 10,1-11% |
| MgO | 4-5% |
| Na₂O | 11-12,4%, notamment 11,5-12% |
| K₂O | 0-1%, notamment 0-0,3%. |

La fusion du verre peut être réalisée en fours continus, chauffés à l'aide d'électrodes et/ou à l'aide de brûleurs, aériens et/ou immergés et/ou disposés dans la voûte du four de manière à ce que la flamme vienne impacter les matières premières ou le bain de verre. Les matières premières sont généralement pulvérulentes et comprennent des matières naturelles (sable, feldspaths, calcaire, dolomie, syénite néphélinique...) ou artificielles (carbonate de sodium ou de potassium, sulfate de sodium...). Les matières premières sont enfournées puis subissent des réactions de fusion au sens physique du terme et diverses réactions chimiques conduisant à l'obtention d'un bain de verre. Le verre en fusion est ensuite acheminé vers une étape de formage pendant laquelle la feuille de verre va prendre sa forme. Le formage est réalisé de manière connue par flottage, c'est-à-dire par déversement du verre fondu (à une viscosité de l'ordre de 3000 Poises) sur un bain d'étain en fusion. Le ruban de verre obtenu est ensuite recuit soigneusement afin d'éliminer toutes contraintes thermiques en son sein, avant d'être découpé aux dimensions voulues. L'épaisseur de la feuille de verre est typiquement comprise entre 2 et 6 mm, notamment entre 2,5 et 4 mm.

L'électrode est de préférence sous forme de couche mince déposée sur le substrat (généralement sur l'intégralité d'une face du substrat), directement en contact avec le substrat ou en contact avec au moins une sous-couche. Il peut s'agir d'une couche mince transparente et électroconductrice, par exemple à base d'oxyde d'étain (dopé au fluor ou à l'antimoine), d'oxyde de zinc (dopé à l'aluminium ou au gallium), ou à base d'oxyde d'étain et d'indium (ITO). Il peut encore s'agir d'une couche mince métallique, par exemple en molybdène. Les couches transparentes sont généralement employées lorsque le substrat est destiné à former le substrat de face avant de la cellule photovoltaïque, comme explicité plus en détail dans la suite du texte. On entend par face avant la face traversée en premier par le rayonnement solaire.

L'électrode sous forme de couche mince peut être déposée sur le substrat par différents procédés de dépôt, tels que le dépôt chimique en phase vapeur (CVD) ou le dépôt par pulvérisation cathodique, notamment assisté par champ magnétique (procédé magnétron). Dans le procédé CVD, des précurseurs halogénures ou organométalliques sont vaporisés et transportés par un gaz vecteur jusqu'à la surface du verre chaud, où ils se décomposent sous l'effet de la chaleur pour former la couche mince. L'avantage du procédé CVD est qu'il est possible de le mettre en oeuvre au sein du procédé de formage de la feuille de verre par flottage. Il est ainsi possible de déposer la couche au moment où la feuille de verre est sur le bain d'étain, à la sortie du bain d'étain, ou encore dans l'étenderie, c'est-à-dire au moment où la feuille de verre est recuite afin d'éliminer les contraintes mécaniques. Le procédé CVD est particulièrement adapté au dépôt de couches d'oxyde d'étain dopé au fluor ou à l'antimoine. Le procédé de pulvérisation cathodique sera quant à lui préférentiellement employé pour le dépôt de couches de molybdène, d'oxyde de zinc dopé ou encore d'ITO.

Le matériau à propriétés photovoltaïques est de type Cu (In,Ga) Se₂ (CIGS). Par (In, Ga) on entend que le matériau peut comprendre In et/ou Ga, selon toutes combinaisons de teneurs possibles : In₁₋ₓGaₓ, x pouvant prendre toute valeur de 0 à 1. Notamment, x peut être nul (matériau de type CIS).

Le matériau photovoltaïque est déposé sur le dispositif semi-conducteur, au-dessus de l'électrode, et généralement au contact de celle-ci. Différentes techniques de dépôt sont possibles, parmi lesquelles on peut citer à titre d'exemples l'évaporation, la pulvérisation cathodique, le dépôt chimique en phase vapeur (CVD), les dépôts électrolytiques ou encore la sublimation (CSS). A titre d'exemple, on peut citer dans le cas des couches de type CIGS les procédés de pulvérisation cathodique ou de dépôt électrolytique (suivis d'une étape de sélénisation) ou la coévaporation.

Une électrode supplémentaire peut être déposée sur (et notamment en contact avec) la couche de matériau photovoltaïque. Il peut s'agir d'une couche mince transparente et électroconductrice, par exemple à base d'oxyde d'étain (dopé au fluor ou à l'antimoine), d'oxyde de zinc (dopé à l'aluminium ou au gallium), ou à base d'oxyde d'étain et d'indium (ITO). Il peut encore s'agir d'une couche métallique, par exemple en or ou en alliage de nickel et d'aluminium. Les couches transparentes sont généralement employées lorsque le substrat est destiné à former le substrat de face arrière de la cellule photovoltaïque, comme explicité plus en détail dans la suite du texte. Des couches tampon peuvent aussi être interposées entre la couche de matériau photovoltaïque et l'électrode supplémentaire. Dans le cas des matériaux de type CIGS, il peut par exemple s'agir d'une couche de CdS.

Un autre objet de l'invention est une cellule photovoltaïque comprenant un dispositif semi-conducteur selon l'invention. Un objet de l'invention est enfin un module photovoltaïque comprenant une pluralité de cellules photovoltaïques selon l'invention.

Suivant la technologie employée, le substrat peut être le substrat de face avant ou comme dans l'invention de face arrière de la cellule photovoltaïque. A titre d'exemple, dans le cas des matériaux photovoltaïques à base de CIGS, la couche de CIGS est généralement déposée sur le substrat de face arrière (muni de son électrode, typiquement en molybdène). C'est donc le substrat de face arrière qui possède alors une feuille de verre ayant la composition chimique avantageuse décrite précédemment. Dans le cas de la technologie CdTe en revanche, le matériau photovoltaïque est souvent déposé sur le substrat de face avant, de sorte que la composition chimique précitée est utilisée pour la feuille de verre du substrat de face avant.

La cellule photovoltaïque est formée en réunissant les substrats de face avant et de face arrière, par exemple au moyen d'un intercalaire de feuilletage en matière plastique thermodurcissable, par exemple en PVB, PU ou EVA. La cellule photovoltaïque comprend comme substrat de face avant un substrat, dont la composition chimique de la feuille de verre comprend en outre de l'oxyde de fer en une teneur pondérale d'au plus 0,02%, notamment 0,015%. Dans ce cas, il importe en effet que la transmission optique du verre soit la plus élevée possible. La feuille de verre ne comprend de préférence aucun agent absorbant les rayonnements visibles ou infrarouges (notamment pour une longueur d'ondes comprise entre 380 et 1000 nm) autre que l'oxyde de fer (dont la présence est inévitable). En particulier, la composition du verre ne contient de préférence pas d'agents choisis parmi les agents suivants, ou aucun des agents suivants : les oxydes d'éléments de transition tels que CoO, CuO, Cr₂O₃, MnO₂, les oxydes de terres rares tels que CeO₂, La₂O₃, Nd₂O₃, ou encore les agents colorants à l'état élémentaire tels que Se, Ag, Cu, Au. Ces agents ont bien souvent un effet colorant indésirable très puissant, se manifestant à de très faibles teneurs, parfois de l'ordre de quelques ppm ou moins (1 ppm = 0,0001%) . Toujours afin de maximiser la transmission optique du verre, le rédox (défini comme le rapport entre la teneur en fer ferreux exprimée sous la forme FeO et la teneur totale en fer exprimée sous la forme Fe₂O₃) est de préférence d'au plus 0,2, notamment 0,1. La feuille de verre est de préférence telle que sa transmission énergétique (T_{E}) calculée selon la norme ISO 9050:2003 est supérieure ou égale à 90%, notamment 90,5%, voire 91% et même 91,5%, pour une épaisseur de 3,2 mm. Le substrat de face avant peut être muni, sur la face opposée à celle portant l'électrode, d'un revêtement antireflet, par exemple en silice poreuse ou comprenant un empilement de couches minces alternant des couches à haut et bas indice de réfraction.

Selon un second mode de réalisation, la cellule photovoltaïque selon l'invention comprend comme substrat de face arrière le substrat selon l'invention, la composition chimique de la feuille de verre dudit substrat comprenant en outre de l'oxyde de fer en une teneur pondérale d'au moins 0,05%, notamment comprise dans une gamme allant de 0,08 à 2%, notamment de 0,08 à 0,2%. Dans le cadre de ce mode de réalisation, on utilise typiquement un substrat selon l'invention muni d'une électrode en molybdène, un matériau photovoltaïque en CIGS, une électrode supplémentaire en ZnO dopé. De fortes teneurs en oxyde de fer (de 0,5% à 2%) peuvent dans ce cas corriger l'aspect esthétique dû à la présence de molybdène. Le substrat de face avant est de préférence en verre extra-clair, de composition silico-sodo-calcique standard.

La présente invention sera mieux comprise à la lecture de la description détaillée ci-après d'exemples de réalisation non limitatifs.

Les tableaux 1 et 2 ci-après illustrent certaines compositions selon l'invention (exemples 1 à 10) ainsi qu'une composition standard (exemple comparatif C1).

Outre la composition chimique pondérale, les tableaux indiquent les propriétés physiques suivantes :
- la température inférieure de recuit, appelée S et exprimée en °C,
- la température à laquelle le verre présente une viscosité de 100 Poises, appelée T2 et exprimée en °C,
- la température à laquelle le verre présente une viscosité de 3162 Poises, appelée T3,5 et exprimée en °C,
- la marge de formage, appelée ΔT et exprimée en °C, correspondant à la différence entre la température T3,5 et la température au liquidus.

**Tableau 1**

| | C1 | 1 | 2 | 3 | 4 |
|---|---|---|---|---|---|
| SiO₂ | 71,8 | 71,8 | 72,0 | 72,8 | 70,9 |
| Al₂O₃ | 0, 6 | 1,35 | 1,3 | 0,9 | 1,8 |
| CaO | 9,5 | 9,9 | 10,0 | 9,8 | 10,0 |
| MgO | 4,0 | 5,5 | 5,6 | 5,7 | 6,2 |
| Na₂O | 13,7 | 10,5 | 10,9 | 10,7 | 10,8 |
| K₂O | 0 | 0,75 | 0 | 0 | 0,1 |
| SO₃ | 0,28 | 0,22 | 0,23 | 0,23 | 0,3 |
| | | | | | |
| S (°C) | 510 | 537 | 542 | 538 | 547 |
| T2 (°C) | 1421 | 1474 | 1475 | 1463 | 1467 |
| T3,5 (°C) | 1093 | 1154 | 1155 | 1147 | 1145 |
| ΔT (°C) | 78 | 14 | 5 | 17 | 45 |

**Tableau 2**

| | 5 | 6 | 7 | 8 | 9 | 10 |
|---|---|---|---|---|---|---|
| SiO₂ | 73,3 | 72,2 | 73,1 | 73,4 | 71,3 | 70,1 |
| Al₂O₃ | 1,6 | 1,7 | 1,95 | 1,8 | 2,0 | 2,1 |
| CaO | 9,6 | 12,8 | 12,6 | 11,9 | 12,8 | 10,6 |
| MgO | 4,8 | 0,1 | 0,3 | 0,9 | 0,1 | 4,3 |
| Na₂O | 10,1 | 11,8 | 11,8 | 11,6 | 11,4 | 11,8 |
| K₂O | 0,38 | 1,3 | 0,06 | 0,08 | 0,4 | 0,7 |
| SO₃ | 0,3 | 0,3 | 0,3 | 0,3 | 0,3 | 0,3 |
| | | | | | | |
| S (°C) | 542 | 536 | 541 | 539 | 539 | 535 |
| T2 (°C) | 1513 | 1469 | 1470 | 1482 | 1451 | 1464 |
| T3,5 (°C) | 1166 | 1132 | 1146 | 1144 | 1133 | 1125 |
| ΔT (°C) | | 22 | | 14 | | 35 |

Les compositions permettent d'obtenir des verres présentant des températures inférieures de recuit d'environ 30°C plus élevées que celle du verre standard. Il en résulte un meilleur comportement mécanique, et des feuilles de verre moins aptes à se déformer durant les étapes de fabrication des cellules solaires.

Ces compositions de verre sont flottables dans de bonnes conditions, comme en témoignent les marges de formage positives. Elles présentent en outre une faible aptitude à la rayure, une faible densité ainsi qu'un indice de réfraction particulièrement bien adapté au procédé de gravure de la couche d'électrode en molybdène.

## Revendications

1. Cellule photovoltaïque comprenant un dispositif semi-conducteur, lequel comprend un substrat pour cellule photovoltaïque et au moins une couche mince d'un matériau à propriétés photovoltaïques déposée sur ledit substrat, ledit matériau à propriétés photovoltaïques étant un composé de type Cu(In,Ga)Se₂, ledit substrat comprenant au moins une feuille de verre flotté munie sur une face d'au moins une électrode, ledit verre possédant une composition chimique comprenant les constituants suivants, en une teneur pondérale variant dans les limites ci-après définies :
| | |
|---|---|
| SiO₂ | 69-75% |
| Al₂O₃ | 0-3% |
| CaO + MgO | 11-16,2% |
| MgO | 0-6,5% |
| Na₂O | 9-12,4% |
| K₂O | 0-1,5%, |
la composition chimique de la feuille de verre dudit substrat comprenant en outre de l'oxyde de fer en une teneur pondérale d'au moins 0,05%, ledit substrat étant le substrat de face arrière de ladite cellule photovoltaïque.

2. Cellule photovoltaïque selon la revendication précédente, telle que la somme des teneurs pondérales en SiO₂, Al₂O₃, CaO, MgO, Na₂O, K₂O est d'au moins 95%, notamment 98%.

3. Cellule photovoltaïque selon l'une des revendications précédentes, telle que la teneur pondérale en MgO est d'au plus 1%, notamment 0,5%.

4. Cellule photovoltaïque selon la revendication précédente, telle que le verre possède une composition chimique comprenant les constituants suivants, en une teneur pondérale variant dans les limites ci-après définies :
| | |
|---|---|
| SiO₂ | 71-74,2% |
| Al₂O₃ | 0-3% |
| CaO | 11,5-13% |
| MgO | 0-1% |
| Na₂O | 11-12,4%, notamment 11-12%, |
| K₂O | 0-1,5%. |

5. Cellule photovoltaïque selon la revendication 1 ou 2, telle que la teneur pondérale en MgO est d'au moins 4%.

6. Cellule photovoltaïque selon la revendication précédente, telle que le verre possède une composition chimique comprenant les constituants suivants, en une teneur pondérale variant dans les limites ci-après définies :
| | |
|---|---|
| SiO₂ | 70-74% |
| Al₂O₃ | 0-2% |
| CaO | 9-10,5% |
| MgO | 4-6% |
| Na₂O | 10-11% |
| K₂O | 0-1%. |

7. Cellule photovoltaïque selon la revendication 5, telle que le verre possède une composition chimique comprenant les constituants suivants, en une teneur pondérale variant dans les limites ci-après définies :
| | |
|---|---|
| SiO₂ | 69-72%, notamment 69-71% |
| Al₂O₃ | 1-3%, notamment 1,7-3% |
| CaO | 10-12%, notamment 10,1-11% |
| MgO | 4-5% |
| Na₂O | 11-12,4%, notamment 11,5-12% |
| K₂O | 0-1%. |

8. Cellule photovoltaïque selon l'une des revendications précédentes, telle que l'électrode est une couche mince en molybdène.

9. Cellule photovoltaïque selon l'une des revendications précédentes, telle que la teneur pondérale en oxyde de fer est comprise dans une gamme allant de 0,08 à 2%.

10. Module photovoltaïque comprenant une pluralité de cellules photovoltaïques selon l'une des revendications précédentes.

## Patentansprüche

1. Photovoltaikzelle, umfassend eine Halbleitervorrichtung, die ein Substrat für die Photovoltaikzelle umfasst, und mindestens eine dünne Schicht eines Materials mit photovoltaischen Eigenschaften, die auf dem Substrat aufgebracht ist, wobei das Material mit photovoltaischen Eigenschaften eine Verbindung vom Typ Cu (In, Ga) Se₂ ist, wobei das Substrat mindestens ein Floatglasscheibe umfasst, die auf einer Seite mit mindestens einer Elektrode ausgestattet ist, wobei das Glas eine chemische Zusammensetzung aufweist, umfassend die folgenden Bestandteile, mit einem Gewichtsanteil, der in den im Folgenden definierten Grenzen variiert:
| | |
|---|---|
| SiO₂ | 69-75 % |
| Al₂O₃ | 0-3 % |
| CaO + MgO | 11-16,2 % |
| MgO | 0-6,5 % |
| Na₂O | 9-12,4 % |
| K₂O | 0-1,5 % |
wobei die chemische Zusammensetzung der Gleasscheibe des Substrats außerdem Eisenoxid mit einem Gewichtsanteil von mindestens 0,05 % umfasst, wobei das Substrat das Substrat der hinteren Seite der Photovoltaikzelle ist.

2. Photovoltaikzelle nach dem vorhergehenden Anspruch, wobei die Summe der Gewichtsanteile von SiO₂, Al₂O₃, CaO, MgO, Na₂O, K₂O mindestens 95 %, insbesondere 98 % beträgt.

3. Photovoltaikzelle nach einem der vorhergehenden Ansprüche, wobei der Gewichtsanteil von MgO höchstens 1 %, insbesondere 0,5 % beträgt.

4. Photovoltaikzelle nach dem vorhergehenden Anspruch, wobei das Glas eine chemische Zusammensetzung aufweist, umfassend die folgenden Bestandteile, mit einem Gewichtsanteil, der in den im Folgenden definierten Grenzen variiert:
| | |
|---|---|
| SiO₂ | 71-74,2 % |
| Al₂O₃ | 0-3 % |
| CaO | 11,5-13 % |
| MgO | 0-1 % |
| Na₂O | 11-12,4 %, insbesondere 11-12 %, |
| K₂O | 0-1,5 %. |

5. Photovoltaikzelle nach Anspruch 1 oder 2, wobei der Gewichtsanteil von MgO 4 % beträgt.

6. Photovoltaikzelle nach dem vorhergehenden Anspruch, wobei das Glas eine chemische Zusammensetzung aufweist, umfassend die folgenden Bestandteile, mit einem Gewichtsanteil, der in den im Folgenden definierten Grenzen variiert:
| | |
|---|---|
| SiO₂ | 70-74 % |
| Al₂O₃ | 0-2 % |
| CaO | 9-10,5 % |
| MgO | 4-6 % |
| Na₂O | 10-11 % |
| K₂O | 0-1 % |

7. Photovoltaikzelle nach Anspruch 5, wobei das Glas eine chemische Zusammensetzung aufweist, umfassend die folgenden Bestandteile, mit einem Gewichtsanteil, der in den im Folgenden definierten Grenzen variiert:
| | |
|---|---|
| SiO₂ | 69-72 %, insbesondere 69-71 % |
| Al₂O₃ | 1-3 %, insbesondere 1,7-3 % |
| CaO | 10-12 %, insbesondere 10,1-11 % |
| MgO | 4-5 % |
| Na₂O | 11-12,4 %, insbesondere 11,5-12 % |
| K₂O | 0-1 % |

8. Photovoltaikzelle nach einem der vorhergehenden Ansprüche, wobei die Elektrode eine dünne Schicht aus Molybdän ist.

9. Photovoltaikzelle nach einem der vorhergehenden Ansprüche, wobei der Gewichtsanteil von Eisenoxid in einem Bereich enthalten ist, der von 0,08 bis 2 % reicht.

10. Photovoltaikmodul, umfassend eine Vielzahl von Photovoltaikzellen nach einem der vorhergehenden Ansprüche.

## Claims

1. Photovoltaic cell comprising a semiconductor device, which comprises a substrate for photovoltaic cell and at least one thin film of a material having photovoltaic properties deposited on said substrate, said material having photovoltaic properties being a compound of Cu(In,Ga)Se₂ type, said substrate comprising at least one sheet of float glass provided on a face of at least one electrode, said glass having a chemical composition comprising the following constituents, in a weight content that varies within the limits defined below:
| | |
|---|---|
| SiO₂ | 69-75% |
| Al₂O₃ | 0-3% |
| CaO + MgO | 11-16.2% |
| MgO | 0-6.5% |
| Na₂O | 9-12.4% |
| K₂O | 0-1.5% |
the chemical composition of the glass sheet of said substrate additionally comprising iron oxide in a weight content of at least 0.05%, said substrate being the back face substrate of said photovoltaic cell.

2. Photovoltaic cell according to the preceding claim, such that the sum of the weight contents of SiO₂, Al₂O₃, CaO, MgO, Na₂O, K₂O is at least 95%, in particular 98%.

3. Photovoltaic cell according to either of the preceding claims, such that the weight content of MgO is at most 1%, in particular 0.5%.

4. Photovoltaic cell according to the preceding claim, such that the glass has a chemical composition comprising the following constituents, in a weight content that varies within the limits defined below:
| | |
|---|---|
| SiO₂ | 71-74.2% |
| Al₂O₃ | 0-3% |
| CaO | 11.5-13% |
| MgO | 0-1% |
| Na₂O | 11-12.4%, especially 11-12% |
| K₂O | 0-1.5%. |

5. Photovoltaic cell according to Claim 1 or 2, such that the weight content of MgO is at least 4%.

6. Photovoltaic cell according to the preceding claim, such that the glass has a chemical composition comprising the following constituents, in a weight content that varies within the limits defined below:
| | |
|---|---|
| SiO₂ | 70-74% |
| Al₂O₃ | 0-2% |
| CaO | 9-10.5% |
| MgO | 4-6% |
| Na₂O | 10-11% |
| K₂O | 0-1%. |

7. Photovoltaic cell according to to Claim 5, such that the glass has a chemical composition comprising the following constituents, in a weight content that varies within the limits defined below:
| | |
|---|---|
| SiO₂ | 69-72%, especially 69-71% |
| Al₂O₃ | 1-3%, especially 1.7-3% |
| CaO | 10-12%, especially 10.1-11% |
| MgO | 4-5% |
| Na₂O | 11-12.4%, especially 11.5-12% |
| K₂O | 0-1%. |

8. Photovoltaic cell according to one of the preceding claims, such that the electrode is a thin film made of molybdenum.

9. Photovoltaic cell according to one of the preceding claims, wherein the weight content of iron oxide is comprised within a range extending from 0.08 to 2%.

10. Photovoltaic module comprising a plurality of photovoltaic cells according to one of the preceding cell claims.
